Europäisches Patentamt

European Patent Office

Office européen des brevets

(11) Veröffentlichungsnummer: **0 187 918 B1**

# EUROPÄISCHE PATENTSCHRIFT

(45) Veröffentlichungstag der Patentschrift: **24.07.91**

(51) Int. Cl.5: **H03H 9/02**

(21) Anmeldenummer: **85114644.9**

(22) Anmeldetag: **18.11.85**

---

(54) **Elektrisches Oberflächenwellenfilter.**

---

(30) Priorität: **17.12.84 DE 3446022**

(43) Veröffentlichungstag der Anmeldung:
**23.07.86 Patentblatt 86/30**

(45) Bekanntmachung des Hinweises auf die
Patenterteilung:
**24.07.91 Patentblatt 91/30**

(84) Benannte Vertragsstaaten:
**BE DE FR GB IT**

(56) Entgegenhaltungen:
**EP-A- 0 098 599**

**PATENT ABSTRACTS OF JAPAN, Band 7, Nr.
243 (E-207) [1388], 28. Oktober 1983 & JP-
A-58-131 809**

**PATENT ABSTRACTS OF JAPAN, Band 1, Nr.
136, 10. November 1977, Seite 6420 E 77 &
JP-A-52-72 137**

(73) Patentinhaber: **Siemens Aktiengesellschaft
Wittelsbacherplatz 2
W-8000 München 2(DE)**

(72) Erfinder: **Faber, Werner, Dr. Ing. Dipl.-Phys.
Erlenweg 4
W-8011 Kirchheim(DE)**

---

**Beschreibung**

Die Erfindung betrifft ein Oberflächenwellenfilter gemäß Oberbegriff des Patentanspruches 1.

Oberflächenwellenfilter sind z.B. durch das Datenbuch "Oberflächenwellen-Filter LIOB", Ausgabe 1983/84, Herausgeber Siemens, bekannt. Sie stellen integrierte, passive Bauelemente mit Bandfiltercharakteristik dar, deren Funktion auf der Interferenz von mechanischen Oberflächenwellen beruht, die sich längs der Oberfläche eines piezoelektrischen Materials ausbreiten. Ihr Aufbau ist durch ein einkristallines, piezoelektrisches Substrat, insbesondere aus Lithiumniobat, gekennzeichnet, auf das eine Metallschicht, insbesondere Aluminiumschicht, aufgetragen, z.B. aufgedampft ist, aus der mittels Photoätztechnik piezoelektrische Einund Ausgangswandler, sogenannte Interdigitalwandler herausgearbeitet sind. Diese bestehen aus mehreren metallisierten kammartigen Elektroden, d.h. aus Elektroden mit Sammelschienen und senkrecht zu diesen ausgerichteten Fingern, die sich in den aktiven Bereichen der Wandler jeweils mit Fingern der Elektroden unterschiedlicher Polarität überlappen. Das Substrat selbst ist auf einen Metallträger aufgeklebt. Die Kontaktierung der Ein- und Ausgangswandler mit den nach außen führenden Anschlüssen erfolgt dabei über Bond-Drähte.

Im Betrieb dieser Oberflächenwellenfilter wird ein in den Eingangswandler eingegebenes Signal in eine mechanische Oberflächenwelle umgewandelt, die auf bzw. in der Oberfläche des Substrats zum Ausgangswandel läuft, der die Oberflächenwelle schließlich in ein elektrisches Signal umwandelt. Die vorstehend bereits erwähnten üblichen Wandler besitzen Interdigitalstrukturen mit Laufzeiteffekten, die mit einer Struktur zur Abschirmung versehen sein können. Sie haben stark frequenzabhängige Eigenschaften, so daß aufgrund der Ausbildung der Strukturen eine Filterwirkung für elektrische Signale erreichbar ist.

Die in den Überlappungsbereichen der Elektroden der Interdigitalwandler angeregten Wellen breiten sich nicht nur in der gewünschten Fortpflanzungsrichtung sondern, bedingt durch Beugungserscheinungen und die durch die Interdigitalstrukturen festgelegte Quellenverteilung auch in Richtung zu den Substrat- bzw. Chiprändern aus. Die auf die kurzen Substratkanten zulaufenden Wellen werden dabei in üblicher Bedämpfungstechnik unter Verwendung verschiedenster Materialien, insbesonder Photolack und/oder Siebdrucklack, abgedämpft, die im Photolack- oder Siebdruckverfahren auf die entsprechende Substratfläche aufgetragen werden. Das Photolackverfahren hat sich dabei als besonders geeignet erwiesen, da sich mit dessen Hilfe die zu realisierenden feinen Strukturen der Bedämpfungsmassen am besten herstellen lassen.

Der vorliegenden Erfindung liegt die Aufgabe zugrunde, ein Oberflächenwellenfilter zu schaffen, das gegebenenfalls falls zusätzlich zur bereits erwähnten bekannten Bedämpfung auch die Wellen bedämpft bzw. weitgehend unterdrückt, die auf die Substratlängskanten zulaufen und am Übergang von der Wandlerstruktur, insbesondere am Übergang von den Sammelschienen der Elektroden zur freien Substratoberfläche sowie an den Substratlängskanten reflektiert werden.

Zur Lösung dieser Aufgabe sieht die Erfindung bei einem elektrischen Oberflächenwellenfilter gemäß Oberbegriff des Patentanspruches 1 vor, daß die Dämpfungsmasse in zu den Substratlängskanten parallelen Streifen auf Teile des inaktiven Interdigitalwandlerbereichs zwischen den Substratlängskanten und dem aktiven Interdigitalwandlerbereich aufgebracht ist, wobei die Dämpfungsmasse mindestens die Sammelschienen eines Interdigitalwandlers vollständig und zusätzlich hieran angrenzende inaktive Interdigitalwandlerbereiche mindestens teilweise bedeckt.

Die Dämpfungsmasse, insbesondere Photolack und/oder Siebdrucklack, kann dabei zusätzlich zu den Sammelschienen den gesamten Bereich zwischen diesen Sammelschienen und den hierzu benachbarten Substratlängskanten und den Bereich zwischen diesen Sammelschienen und dem durch die Elektrodenfinger größter Überlappung bestimmten aktiven Interdigitalwandlerbereich bedecken.

Dabei ist bevorzugt der überlappungsfreie inaktive Interdigitalwandlerbereich durch Wahl einer geeigneten Elektrodenfingerlänge so groß gewählt, daß ausreichend Fläche für die Auftragung der Dämpfungsmasse zur Verfügung steht.

Die Erfindung wird nachstehend anhand eines Ausführungsbeispieles näher erläutert. Es zeigt:

Fig. 1    in schematischer, teils gebrochener und vereinfachter Darstellung eine Draufsicht auf einen Interdigitalwandler eines Oberflächenwellenfilters nach der Erfindung, bei dem der aktive und die inaktiven Interdigitalwandler-Bereiche angedeutet und die Wandlerfinger aus Gründen der Anschaulichkeit lediglich mit ihren zueinander gekehrten Enden wiedergegeben sind.

Fig. 2    in gleichfalls schematischer und teilweiser vereinfachter Darstellung eine Draufsicht auf ein Oberflächenwellenfilter nach der Erfindung mit dem in Fig. 1 in vergrößertem Maßstab gezeigten Interdigitalwandler.

Fig. 3    einen Vergleich der Durchlaßkurven für ein Oberflächenwellenfilter nach Fig. 1, 2, wobei die Kurve "a" die Durchlaßkurve für ein auf der kurzen und langen Substratseite bedämpftes Filter und die Kurve "b" die Durchlaßkurve für ein nur auf der kurzen Substratseite bedämpftes Filter wiedergibt.

Fig. 4 einen Ausschnitt der Durchlaßkurven
nach Fig.3 in vergrößertem Maßstab,
aus dem die unterschiedliche Dachwelligkeit des "voll" und des nur
"teilbedämpften" Filters erkennbar ist.

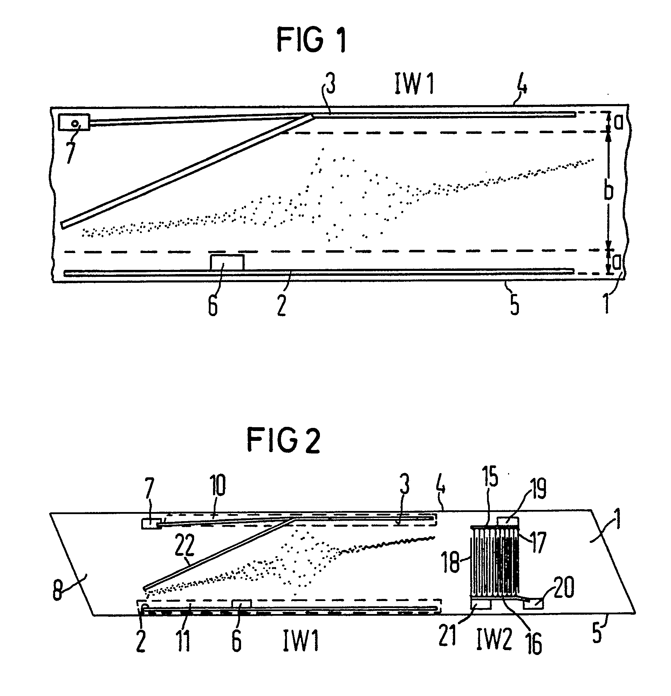

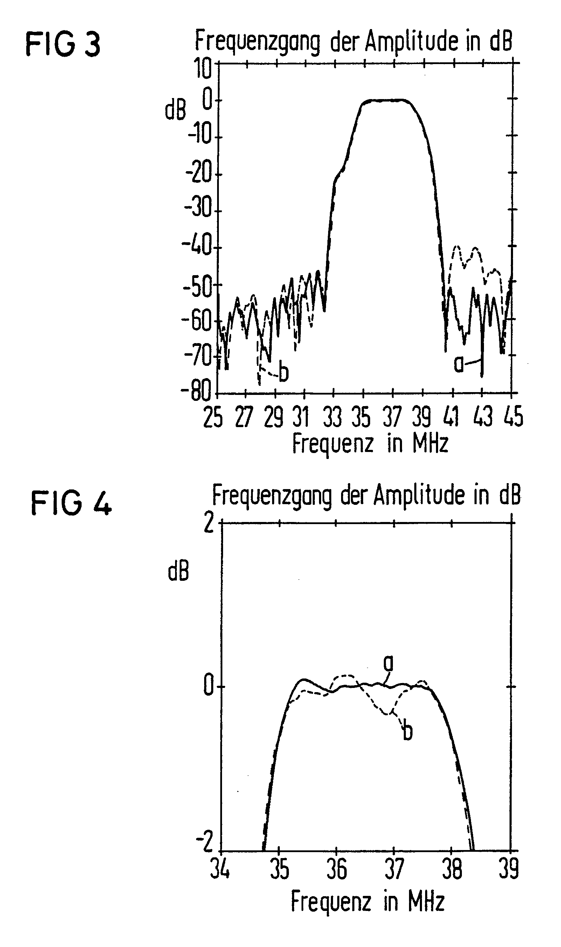

Das elektrische Oberflächenfilter nach Fig. 1, 2
besitzt ein plättchenförmiges Substrat 1 aus einkristallinem, piezoelektrischem Werkstoff, nämlich Lithiumniobat. Dessen eine Substratseite trägt zur
Anregung und Auskopplung der Oberflächenwellen
Interdigitalwandler IW 1 und IW 2. Beide Interdigitalwandler bestehen aus z.B. auf das Substrat aufgedampften metallischen Strukturen, deren Elektroden kammartig gestaltet sind und sich in den aktiven Interdigitalwandler-Bereichen mit ihren Elektrodenfingern 17, 18 überlappen. Die Elektrodenfinger
der Interdigitalwandler sind dabei jeweils über
Sammelschienen 3, 22; 2 bzw. 15, 16 und Kontakflächen 7;6 bzw. 19; 20, 21 angeschaltet. Zwischen
dem aktiven Interdigitalwandler-Bereich "b" und
den benachbarten Substratlängskanten 4, 5 des
Interdigitalwandlers IW 1 sind - wie dies in Fig. 2
strichliniert angedeutet ist - Dämpfungsmassen 10,
11, z.B. Photolack und/oder Siebdrucklack auf das
Substrat aufgebracht. Im gezeigten Ausführungsbeispiel bedeckt dabei jede Dämpfungsmasse 10
bzw. 11 einen inaktiven Interdigitalwandler-Bereich
a, a; d.h. einen Bereich in dem sich die, lediglich
durch ihre Enden angedeuteten, Elektrodenfinger
unterschiedlicher Polarität nicht überlappen, und
zusätzlich die Sammelschienen 3 bzw. 2. Die
Fig.3,4 zeigen für ein Oberflächenwellenfilter nach
Fig. 1,2 die Filterdurch-laßkurven, d.h. den über der
Frequenz aufgetragenen Frequenzgang der Amplitude, ausgedrückt in dB. Mit "a" ist dabei die
Durchlaßkurve bezeichnet, die man bei Bedämpfung des Filters längs der kurzen und der langen
Substratkante 8 bzw. 4, 5 erhält; wohingegen die
Kurve "b" lediglich die Werte wiedergibt, die man
bei ausschließlicher Bedämpfung längs der kurzen
Substratkante 8 erhält.

Die Fig. 3 läßt klar erkennen, daß durch die
erfindungsgemäße Bedämpfung der Sperrbereich
oberhalb der Filterdurchlaßkurve erheblich verbessert wird. Im vergrößerten Maßstab nach Fig. 4 ist
darüberhinaus klar ersichtlich, daß die Dachwelligkeit durch den erfindungsgemäßen Vorschlag erheblich vermindert wird.

## Patentansprüche

1. Elektrisches Oberflächenwellenfilter mit einem
plättchenförmigen Substrat, das aus einkristallinem, piezoelektrischem Werkstoff, insbesondere Lithiumniobat, besteht, dessen eine Substratseite zur Anregung und Auskopplung von
Oberflächenwellen dienende Interdigitalwandler
trägt, bestehend aus ineinander greifenden
Kammelektroden mit jeweils metallischen Sammelschienen und mit diesen kontaktierten Elektrodenfingern, die sich in den aktiven, die
Oberflächenwellen erregenden bzw. empfangenden Interdigitalwandlerbereichen überlappen und mit einer plastischen Dämpfungsmasse, elastischen Dämpfungsmasse oder einer
Kombination aus diesen Dämpfungsmassen,
die zur Unterdrückung im Substrat auftretender
störender Wellenreflexionen dient, **dadurch
gekennzeichnet, daß** die Dämpfungsmasse
in zu den Substratlängskanten parallelen Streifen auf Teile des inaktiven Interdigitalwandlerbereichs zwischen den Substratlängskanten
und dem aktiven Interdigitalwandlerbereich aufgebracht ist, wobei die Dämpfungsmasse mindestens die Sammelschienen eines Interdigitalwandlers vollständig und zusätzlich hieran angrenzende inaktive Interdigitalwandlerbereiche
mindestens teilweise bedeckt.

2. Elektrisches Oberflächenwellenfilter nach Anspruch 1, **dadurch gekennzeichnet, daß** die
Dämpfungsmasse zusätzlich zu den Sammelschienen den gesamten Bereich zwischen diesen Sammelschienen und den hierzu benachbarten Substratlängskanten und den Bereich
zwischen diesen Sammelschienen und dem
durch die Elektrodenfinger größter Überlappung bestimmten aktiven Interdigitalwandlerbereich bedeckt.

3. Elektrisches Oberflächenwellenfilter nach Anspruch 1, **dadurch gekennzeichnet, daß** der
überlappungsfreie inaktive Interdigitalwandlerbereich durch Wahl einer geeigneten Elektrodenfingerlänge so groß gewählt ist, daß ausreichend Fläche für die Auftragung der Dämpfungsmasse zur Verfügung steht.

4. Elektrisches Oberflächenwellenfilter nach Anspruch 1, **dadurch gekennzeichnet, daß** die
Dämpfungsmesse Fotolack und/oder Siebdrucklack ist.

## Claims

1. Electrical surface wave filter having a wafershaped substrate, which consists of monocrystalline, piezoelectric material, preferably
lithium niobate, and whose one substrate side
supports interdigital transducers, which serve
to excite and couple out surface waves and
consist of mutually engaging comb electrodes, having metallic bus bars in each case, and having electrode fingers which are contacted with the latter and overlap in the active regions, exciting or receiving the surface waves, of the interdigital transducer and having a plastic damping material, elastic damping material or a combination of these damping materials, which serves to suppress disturbing wave reflections occurring in the substrate, characterised in that the damping material is applied in strips parallel to the longitudinal edges of the substrate to parts of the inactive region of the interdigital transducer between the longitudinal edges of the substrate and the active region of the interdigital transducer, the damping material covering at least the bus bars of one interdigital transducer completely and, in addition, inactive regions adjacent hereto of the interdigital transducer at least partially.

2. Electrical surface wave filter according to Claim 1, characterised in that, in addition to the bus bars, the damping material covers the entire region between these bus bars and the longitudinal edges adjacent hereto of the substrate and the region between these bus bars and the active region of the interdigital transducer defined by the greatest overlap of the electrode fingers.

3. Electrical surface wave filter according to Claim I, characterised in that by choosing a suitable electrode finger length, the overlap-free inactive region of the interdigital transducer is chosen so large that an adequate area is available for the application of the damping material.

4. Electrical surface wave filter according to Claim 1, characterised in that the damping material is a photoresist and/or a silk-screen lacquer.

**Revendications**

1. Filtre électrique à ondes de surface comportant un substrat en forme de plaquette constitué par un matériau piézoélectrique monocristallin, notamment du niobate de lithium et dont une face porte des transducteurs interdigités utilisés pour l'excitation et le couplage des ondes de surface et constitués par des électrodes en forme de peignes qui s'interpénètrent et comportent des barres collectrice métalliques respectives et des doigts, que contactent ces barres collectrices et qui se chevauchent dans les régions actives des transducteurs interdigités, qui excitent ou reçoivent les ondes de surface, et comportant une masse plastique d'amortissement, une masse élastique d'amortissement ou une combinaison de ces masses d'amortissement, qui sert à supprimer des réflexions d'ondes parasites, qui apparaissent dans le substrat, caractérisé par le fait que la masse d'amortissement est déposée sous la forme de bandes parallèles aux grands côtés du substrat, sur des parties de la région inactive des transducteurs interdigités entre les grands côtés du substrat et la région active des transducteurs interdigités, la masse d'amortissement recouvrant complètement au moins les barres collectrices d'un transducteur interdigité et en outre au moins partiellement des régions inactives des transducteurs interdigités, qui jouxtent ces barres.

2. Filtre électrique d'ondes de surface suivant la revendication 1, caractérisé par le fait que la masse d'amortissement recouvre, outre les barres collectrices, l'ensemble de la région située entre ces barres collectrices et les grands côtés du substrat, voisins de ces barres, et recouvre la région située entre ces barres collectrices et la région active des transducteurs interdigités, qui est déterminée par le chevauchement maximum par les doigts des électrodes.

3. Filtre électrique de surface suivant la revendication 1, caractérisé par le fait que grâce au choix d'une longueur appropriée des doigts des électrodes, la région inactive des transducteurs interdigités qui ne comporte aucun chevauchement, est suffisamment étendue pour qu'une surface suffisante soit disponible pour le dépôt de la masse d'amortissement.

4. Filtre électrique d'ondes de surface suivant la revendication 1, caractérisé par le fait que la masse d'amortissement est une laque photosensible et/ou une laque de sérigraphie.

## FIG 1

## FIG 2

FIG 3

Frequenzgang der Amplitude in dB

FIG 4

Frequenzgang der Amplitude in dB